Europäisches Patentamt

**European Patent Office**

**Office européen des brevets**

(19)

(11) Numéro de publication : **0 049 380**
**B1**

(12)

# FASCICULE DE BREVET EUROPÉEN

(45) Date de publication du fascicule du brevet :
**13.06.84**

(21) Numéro de dépôt : **81107135.6**

(22) Date de dépôt : **10.09.81**

(51) Int. Cl.³ : **C 23 C 11/00**, C 23 C 15/00

(54) Dispositif de déposition chimique activée sous plasma.

(30) Priorité : **17.09.80 FR 8019983**

(43) Date de publication de la demande :
**14.04.82 Bulletin 82/15**

(45) Mention de la délivrance du brevet :
**13.06.84 Bulletin 84/24**

(84) Etats contractants désignés :
**AT BE CH DE FR GB IT LI LU NL SE**

(56) Documents cités :
**DD-A- 107 723**
**DE-A- 2 951 453**
**FR-A- 2 354 393**
**IBM TECHNICAL DISCLOSURE BULLETIN, vol. 14,**
**no. 9, février 1972 NEW YORK (US) R.R. GARNACHE**
**et al.: "Gas Injection System" page 2551**

(73) Titulaire : **COMPAGNIE INDUSTRIELLE DES TELE-**
**COMMUNICATIONS CIT-ALCATEL S.A. dite:**
**12, rue de la Baume**
**F-75008 Paris (FR)**

(72) Inventeur : **Bessot, Jean-Jacques**
**6, Impasse du Clos Bailly**
**F-91290 Arpajon (FR)**
Inventeur : **Bourdon, Bernard**
**3, Rue des Roses**
**F-91400 Gometz le Chatel (FR)**

(74) Mandataire : **Weinmiller, Jürgen et al**
**Zeppelinstrasse 63**
**D-8000 München 80 (DE)**

Jouve, 18, rue St-Denis, 75001 Paris, France

**Description**

La présente invention concerne un dispositif de déposition chimique activée sous plasma.

La déposition chimique activée consiste à réaliser en phase gazeuse une réaction chimique dans une enceinte de sorte que l'un des produits de la réaction se dépose sur les substrats à recouvrir, les autres s'éliminant sous forme gazeuse.

Une telle réaction est activée en chauffant les substrats et le gaz réactif ou en créant et en maintenant une décharge électrique dans les gaz, ce qui a pour effet d'ioniser une partie des molécules gazeuses et d'augmenter l'activité chimique des autres.

Une telle ionisation des gaz évite de chauffer les substrats à des températures élevées, de l'ordre de 1 000 à 1 200 °C, le dépôt pouvant alors être effectué à température ambiante ou à une température de 200 à 300 °C seulement.

L'amorçage et l'entretien de la décharge électrique peuvent être effectués au moyen d'un champ électromagnétique alternatif à haute fréquence par une bobine, ce procédé étant dénommé « Système Inductif ».

On peut également utiliser un champ électrique continu ou à haute fréquence créé entre deux électrodes polarisées à haute tension, ce procédé étant connu sous le nom de « Système Capacitif ».

En ce qui concerne les enceintes ou réacteurs, on connaît des réacteurs de forme tubulaire utilisés dans les deux systèmes ou de forme dite « planaire » exploités uniquement dans le système capacitif et dans lesquels les électrodes sont formées de plateaux parallèles.

Le mode d'introduction des gaz réactifs dans de telles enceintes joue un rôle important dans la réalisation de couches d'épaisseur uniforme, la vitesse du dépôt des couches, et leur qualité. En effet, il importe que les gaz soient uniformément répartis au niveau des substrats afin d'obtenir des dépôts présentant les caractéristiques avantageuses évoquées dans ce qui précède.

Dans certains dispositifs connus, les distributeurs de gaz présentent une forme annulaire de diamètre égal ou légèrement supérieur à celui de l'électrode porte-substrats et ils sont disposés parallèlement à ladite électrode ; ils comportent des orifices par lesquels les gaz s'échappent et viennent irriguer les substrats.

Les distributeurs de gaz peuvent également présenter une forme tubulaire percée de petits trous ou même être rectilignes, les substrats se déplaçant devant les distributeurs dans ce dernier cas.

Les dispositifs de déposition chimique connus mettant en œuvre des organes d'injection de gaz tels que précédemment décrits, ainsi que notamment des électrodes génératrices de plasma de type courant sont le siège de gradients de pression, de variations de concentration gazeuse, de non-uniformité d'ionisation, ce qui entraîne la formation de couches d'épaisseur non uniforme et de mauvaise qualité.

De plus de tels dispositifs présentent une capacité de production réduite, et sont difficilement transposables à un échelon industriel.

En outre leur prix de revient de construction est relativement élevé.

La présente invention permet de remédier aux inconvénients schématisés dans ce qui précède, et elle a pour but un dispositif de déposition chimique activée sous plasma permettant de réaliser des dépôts uniformes et d'excellente qualité, tout en présentant une structure simple et une fiabilité élevée.

L'invention a donc pour objet un dispositif de déposition chimique activée sous plasma, du type comportant une enceinte ou réacteur maintenu sous vide présentant un axe de symétrie et étant obturé au moyen d'une platine supérieure et d'une platine inférieure amovibles, un porte-substrats, un distributeur de gaz réactifs et des moyens pour amorcer et entretenir un plasma dans ladite enceinte, caractérisé par le fait que ledit distributeur de gaz réactifs comprend deux embases circulaires réunies par des tubes percés d'orifices d'échappement des gaz, ce distributeur étant entraîné en rotation et à vitesse uniforme autour de l'axe de l'enceinte et à l'intérieur dudit porte-substrats, ledit porte-substrats présentant une section polygonale et étant constitué de facettes rectangulaires verticales sur lesquelles sont disposés les substrats en vis-à-vis des orifices dudit distributeur.

L'invention sera décrite ci-après plus en détail à l'aide de plusieurs modes de réalisation donnés à titre d'exemple purement illustratif mais nullement limitatif, en référence aux dessins annexés dans lesquels :

La figure 1 représente un premier mode de réalisation du dispositif selon l'invention.

La figure 2 représente une coupe selon la ligne II-II de la figure 1.

La figure 3 représente un deuxième mode de réalisation du dispositif selon l'invention.

La figure 4 représente une coupe selon la ligne IV-IV de la figure 3.

La figure 5 représente un troisième mode de réalisation du dispositif selon l'invention.

La figure 6 représente une coupe selon la ligne VI-VI de la figure 5.

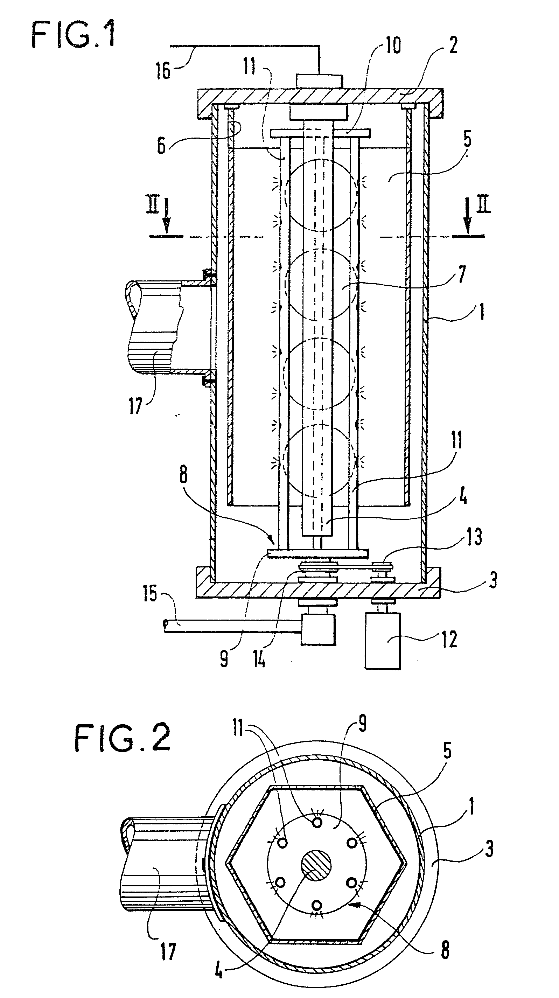

En référence aux figures 1 et 2 le dispositif selon l'invention comprend une enceinte cylindrique ou réacteur 1 qui est obturé au moyen d'une platine supérieure amovible 2 et d'une platine inférieure 3 également amovible. Au centre de l'enceinte 1 est disposée une électrode cylindrique 4 génératrice de plasma avec une contre-électrode, cette électrode étant fixée par l'une de ses extrémités à la platine supérieure 2.

En outre, autour de l'électrode 4 est disposé concentriquement un tonneau porte-substrats 5 jouant le rôle de contre-électrode fixé à ladite platine supérieure 2 au moyen de tirants tels que 6. Ce tonneau présente une section polygonale, en l'occurrence hexagonale, et il est donc formé de 6 facettes rectangulaires verticales sur lesquelles sont disposés les substrats tels que 7. Il peut être équipé d'un dispositif de chauffage ou de refroidissement (non représenté). La référence 8 désigne un distributeur rotatif des gaz réactifs disposé entre l'électrode 4 et le tonneau 5 et d'axe commun.

Ce distributeur, en forme de cage d'écureuil, comporte deux embases circulaires 9 et 10 réunies par des tubes 11 percés de petits orifices aptes à diriger le gaz vers les substrats 7. Ce distributeur est entraîné en rotation par un moteur extérieur 12 et des roues motrices couplées 13 et 14. Il est alimenté en gaz au moyen d'une tubulure 15 traversant la platine inférieure 3.

Le tonneau 5, l'enceinte 1 et le distributeur 8 peuvent être réalisés par exemple en acier inoxydable.

Par ailleurs, l'électrode 4 est connectée à une source de haute tension négative si la tension est continue, ou à haute fréquence si la tension est alternative et cela au moyen d'un câble 16, la contre-électrode étant reliée à la masse. Elle peut également être refroidie à l'eau si nécessaire.

Enfin, une canalisation 17 relie l'enceinte 1 à un groupe de pompage (non représenté).

L'électrode 4 peut être confectionnée en cuivre, en aluminium ou en acier inoxydable. Avantageusement elle est recouverte d'un matériau non polluant pour la couche déposée sur les substrats tel que le silicium, le chrome, ou autres selon le cas. Il faut noter également que sa longueur est de préférence sensiblement supérieure à celle du tonneau 5 dans le but d'uniformiser le champ électrique aux extrémités.

Lorsque l'électrode 4 est mise sous tension, par rapport à la contre-électrode soit 100 à 10 000 volts, un plasma se trouve créé dans l'enceinte 1. Le ou les gaz réactifs sont admis dans l'enceinte 1 par le distributeur rotatif 8 qui dirige lesdits gaz en direction des substrats 7 selon une orientation permettant une uniformité maximale de distribution. Ce distributeur tourne d'ailleurs d'un mouvement uniforme pendant toute la durée du dépôt permettant ainsi d'avoir une égale répartition de l'approvisionnement en gaz à chaque instant, sur la totalité des substrats. Il en résulte un dépôt uniforme de matière sur lesdits substrats. Lorsque le dépôt est terminé on retire la platine 2, l'électrode 4 et le tonneau 5 que l'on peut décharger dans une chambre ou sas surmontant l'enceinte 1.

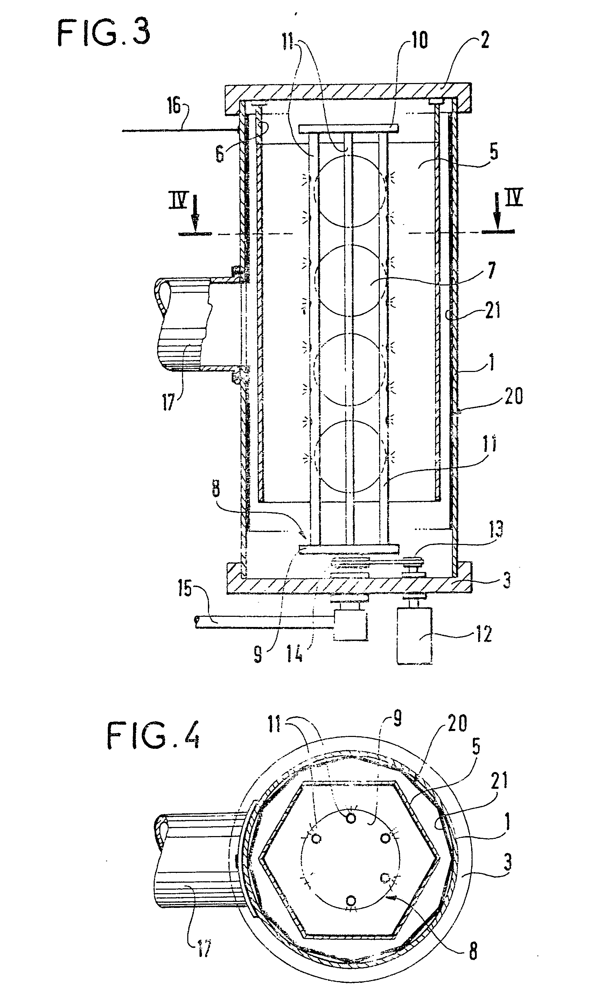

Dans le mode de réalisation représenté aux figures 3 et 4 les mêmes organes sont désignés par les mêmes références que précédemment. Cependant l'électrode n'est plus disposée au centre de l'enceinte 1.

Dans ce cas, l'électrode 20 est fixée ou intégrée à la paroi interne de l'enceinte 1 sous forme d'éléments rectangulaires 21 formant un ensemble de périmètre polygonal.

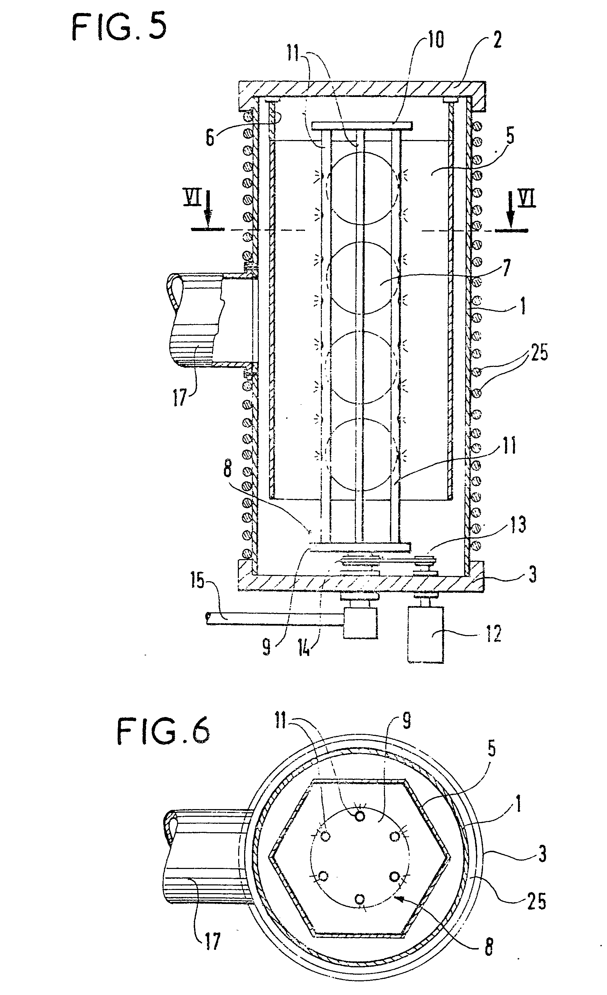

Dans le mode de réalisation illustré aux figures 5 et 6 il n'y a plus d'électrode comme dans les cas précédents car le dispositif fonctionne selon le système inductif au lieu de mettre en œuvre le système capacitif comme dans les précédents modes de réalisation.

A cet effet, on utilise une bobine inductrice 25 alimentée par un courant à haute fréquence, apte à créer et à entretenir le plasma dans l'enceinte 1.

Cette bobine 25 est disposée à l'extérieur de l'enceinte 1 laquelle dans ce cas est confectionnée en silice.

Cependant ladite bobine peut également être disposée à l'intérieur de ladite enceinte 1 qui dans ce cas est métallique ; la bobine doit cependant être revêtue d'un matériau non contaminant vis-à-vis des substrats en raison des effets de pulvérisation de ladite bobine par le plasma.

Des variantes au dispositif selon l'invention peuvent être envisagées.

C'est ainsi qu'il est possible d'élever le degré d'ionisation du plasma en superposant un champ magnétique au champ électrique dans le cas du fonctionnement en système capacitif. Le champ magnétique parallèlement à la surface de l'électrode peut être créé par une bobine extérieure, ou par un empilement d'aimants noyés dans l'électrode génératrice de plasma.

On augmente ainsi la vitesse des dépôts par augmentation de l'activité des molécules.

De même, les substrats 7 peuvent éventuellement être soumis à une source de tension de polarisation continue négative ou alternative à haute fréquence de sorte que certaines particules indésirables soient repoussées et que lesdits substrats subissent un nettoyage ionique avant le dépôt. Dans ce cas le tonneau porte-substrat 5 est connecté à ladite source de tension. On peut également envisager d'entraîner le tonneau 5 en rotation pendant le dépôt, autour de l'axe du réacteur 1.

En outre, lorsque les substrats 7 présentent des formes complexes, il peut être avantageux de les entraîner en rotation sur eux-mêmes par tout moyen approprié.

L'invention est mise en œuvre pour réaliser notamment des dépôts de métaux tels que le silicium, le chrome, l'aluminium et autres.

**Revendications**

1. Dispositif de déposition chimique activée sous plasma, du type comportant une enceinte ou réacteur (1) maintenu sous vide présentant un axe de symétrie et étant obturé au moyen d'une platine supérieure (2) et d'une platine inférieure (3) amovibles, un porte-substrats (5), un distributeur de gaz réactifs (8) et des moyens pour amorcer et entretenir un plasma dans ladite enceinte (1) caractérisé par le fait que ledit distributeur de gaz réactif (8) comprend deux embases circulaires (9, 10) réunies par des tubes (11) percés d'orifices d'échappement des gaz, ce distributeur étant entraîné en rotation et à vitesse uniforme autour de l'axe de l'enceinte et à l'intérieur dudit porte-substrats (5), ledit porte-substrats présentant une section polygonale et étant constitué de facettes rectangulaires verticales sur lesquelles sont disposés les substrats (7) en vis-à-vis des orifices dudit distributeur (8).

2. Dispositif selon la revendication 1, caractérisé par le fait que lesdits moyens pour amorcer et entretenir un plasma dans ladite enceinte (1) comportent une électrode cylindrique (4) disposée au centre de ladite enceinte (1) et fixée par l'une de ses extrémités à ladite platine supérieure (2).

3. Dispositif selon la revendication 1, caractérisé par le fait que lesdits moyens pour amorcer et entretenir un plasma dans ladite enceinte (1) comportent une électrode (20) fixée ou intégrée à la paroi interne de ladite enceinte (1), cette électrode (20) étant formée d'éléments rectangulaires (21) formant un ensemble de périmètre polygonal.

4. Dispositif selon l'une des revendications 1 à 3, caractérisé par le fait que ladite électrode (4) est connectée à une source de tension négative continue.

5. Dispositif selon l'une des revendications 1 à 3, caractérisé par le fait que ladite électrode (4) est connectée à une source de tension alternative à haute fréquence.

6. Dispositif selon l'une des revendications 1 à 5, caractérisé par le fait qu'il comporte en outre des moyens aptes à créer un champ magnétique parallèlement à la surface de ladite électrode (4).

7. Dispositif selon la revendication 6, caractérisé par le fait que lesdits moyens comportent une bobine disposée à l'extérieur de l'enceinte (1).

8. Dispositif selon la revendication 6, caractérisé par le fait que lesdits moyens comportent des aimants associés à l'électrode génératrice de plasma (4).

9. Dispositif selon la revendication 1, caractérisé par le fait que lesdits moyens pour amorcer et entretenir un plasma dans ladite enceinte (1) comportent une bobine inductrice (25) disposée à l'intérieur de l'enceinte (1).

10. Dispositif selon la revendication 1, caractérisé par le fait que lesdits moyens pour amorcer et entretenir un plasma dans ladite enceinte (1) comportent une bobine inductrice (25) disposée à l'intérieur de l'enceinte (1).

11. Dispositif selon l'une des revendications 1 à 10, caractérisé par le fait que ledit porte-substrats (5) est connecté à une source de tension de polarisation continue négative ou à une source de tension alternative à haute fréquence.

12. Dispositif selon l'une des revendications 1 à 11, caractérisé par le fait que ledit porte-substrat (5) est entraîné en rotation autour de l'axe de l'enceinte.

13. Dispositif selon l'une des revendications 1 à 12, caractérisé par le fait que lesdits substrats (7) sont entraînés en rotation sur eux-mêmes.

**Claims**

1. A device for a chemically activated deposition in a plasma, of the type comprising a chamber or reactor (1) in which a vacuum is maintained and which has an axis of symmetry and is closed by means of an upper (2) and a lower removable end plate (3), a substrate support (5), a distributor (8) of reactive gases, and means for setting up and maintaining a plasma inside said chamber (1), characterized in that said distributor (8) of reactive gases comprises two circular end portions (9, 10) interconnected by pipes (11), said pipes being provided with gas outlet orifices, said distributor rotating at uniform speed about the axis of the chamber and inside said substrate support (5), said substrate support being of polygonal cross-section and being constituted by rectangular longitudinally extending facets on which the substrates (7) are deposited facing the orifices of said distributor (8).

2. A device according to claim 1, characterized in that said means for setting up and maintaining a plasma inside said chamber (1) include a cylindrical electrode (4) disposed in the centre of said chamber (1) and fixed at one of its ends to said upper end plate (2).

3. A device according to claim 1, characterized in that said means for setting up and maintaining a plasma inside said chamber (1) include an electrode (20) which is fixed on or built into the inner wall of said chamber (1), this electrode (20) being formed by rectangular components (21) which form an assembly of polygonal perimeter.

4. A device according to one of the claims 1 to 3, characterized in that said electrode (4) is connected to a negative DC voltage source.

5. A device according to one of the claims 1 to 3, characterized in that said electrode (4) is connected to a high frequency AC voltage source.

6. A device according to one of the claims 1 to 5, characterized in that it further includes means suitable for setting up a magnetic field parallel to the surface of said electrode (4).

7. A device according to claim 6, characterized in that said means include a winding disposed outside the chamber (1).

8. A device according to claim 6, characterized in that said means include magnets associated with the plasma-generating electrode (4).

9. A device according to claim 1, characterized in that said means for setting up and maintaining a plasma in said chamber (1) include an induction winding (25) disposed outside the chamber (1).

10. A device according to claim 1, characterized in that said means for setting up and maintaining a plasma in said chamber (1) include an induction winding (25) disposed inside the chamber (1).

11. A device according to one of the claims 1 to 10, characterized in that said substrate support (5) is connected to a negative DC voltage source or a high-frequency AC voltage source.

12. A device according to one of the claims 1 to 11, characterized in that said substrate support (5) is rotatable about the axis of the chamber.

13. A device according to one of the claims 1 to 12, characterized in that said substrates (7) are rotatable about themselves.

## Ansprüche

1. Vorrichtung zur aktivierten chemischen Beschichtung im Plasma, von dem Typ, der einen unter Vakuum gehaltenen Behälter oder Reaktor (1) mit einer Symmetrieachse, der mittels einer oberen (2) und einer unteren entfernbaren Platte (3) verschlossen ist, einen Substratträger (5), einen Verteiler für Reaktionsgase (8) und Mittel zum Aufbau und zur Aufrechterhaltung eines Plasmas in dem genannten Behälter (1) aufweist, dadurch gekennzeichnet, daß der Verteiler der Reaktionsgase (8) zwei kreisförmige Grundplatten (9, 10) aufweist, die durch mit Öffnungen für den Gasauslaß versehene Rohre (11) verbunden sind, wobei dieser Verteiler mit gleichmäßiger Geschwindigkeit um die Achse des Behälters im Inneren des Substratträgers (5) in Drehung versetzt wird, wobei der Substratträger einen polygonalen Querschnitt aufweist und aus rechteckigen senkrechten Facetten besteht, auf denen die Substrate (7) gegenüber den Öffnungen des Verteilers (8) angeordnet sind.

2. Vorrichtung nach Anspruch 1, dadurch gekennzeichnet, daß die Mittel für den Aufbau und die Aufrechterhaltung eines Plasmas in dem Behälter (1) eine zylindrische Elektrode (4) aufweisen, die im Zentrum des Behälters (1) angeordnet ist und mit einem ihrer Enden an der oberen Platte (2) befestigt ist.

3. Vorrichtung nach Anspruch 1, dadurch gekennzeichnet, daß die Mittel für den Aufbau und die Aufrechterhaltung eines Plasmas in dem Behälter (1) eine Elektrode (20) aufweisen, die an der Innenwand des Behälters (1) befestigt ist oder mit ihr eine Einheit bildet, wobei diese Elektrode (20) aus rechteckigen Elementen (21) besteht, die eine Einheit mit polygonalem Umfang bilden.

4. Vorrichtung nach einem der Ansprüche 1 bis 3, dadurch gekennzeichnet, daß die Elektrode (4) an eine Quelle negativer Gleichspannung angeschlossen ist.

5. Vorrichtung nach einem der Ansprüche 1 bis 3, dadurch gekennzeichnet, daß die Elektrode (4) an eine Wechselspannungsquelle hoher Frequenz angeschlossen ist.

6. Vorrichtung nach einem der Ansprüche 1 bis 5, dadurch gekennzeichnet, daß sie außerdem Mittel aufweist, die ein magnetisches Feld parallel zur Oberfläche der Elektrode (4) bilden können.

7. Vorrichtung nach Anspruch 6, dadurch gekennzeichnet, daß die Mittel eine Spule aufweisen, die außerhalb des Behälters (1) angeordnet ist.

8. Vorrichtung nach Anspruch 6, dadurch gekennzeichnet, daß die Mittel Magneten aufweisen, die der plasmaerzeugenden Elektrode (4) zugeordnet sind.

9. Vorrichtung nach Anspruch 1, dadurch gekennzeichnet, daß die Mittel für den Aufbau und die Aufrechterhaltung eines Plasmas in dem Behälter (1) eine Induktionsspule (25) aufweisen, die außerhalb des Behälters (1) angeordnet ist.

10. Vorrichtung nach Anspruch 1, dadurch gekennzeichnet, daß die Mittel für den Aufbau und die Aufrechterhaltung eines Plasmas in dem Behälter (1) eine Induktionsspule (25) im Inneren des Behälters (1) aufweisen.

11. Vorrichtung nach einem der Ansprüche 1 bis 10, dadurch gekennzeichnet, daß der Substratträger (5) an eine Quelle negativer Polarisations-Gleichspannung oder an eine hochfrequente Wechselspannungsquelle angeschlossen ist.

12. Vorrichtung nach einem der Ansprüche 1 bis 11, dadurch gekennzeichnet, daß der Substratträger (5) um die Achse des Behälters in Drehung versetzt wird.

13. Vorrichtung nach einem der Ansprüche 1 bis 12, dadurch gekennzeichnet, daß die Substrate (7) in Drehung um sich selbst versetzt werden.

FIG.1

FIG.2

# FIG.3

# FIG.4

# FIG.5

# FIG.6